# EUROPEAN PATENT APPLICATION

(11) **EP 1 557 881 A1**
(43) Date of publication of application: **27.07.2005**
(21) Application number: 04100241.1
(22) Date of filing: 23.01.2004
(51) Int. Cl.: H01L 23/495

(54) **A lead-frame for electronic devices with extruded pads**

(71) Applicant: STMicroelectronics S.r.l., 20041 Agrate Brianza (Milano) (IT)
(72) Inventor: Deodato, Claudio, I-20093, Cologno Monzese (MI) (IT); Casati, Paolo, I-20099, Sesto S. Giovanni (MI) (IT)
(74) Representative: Pezzoli, Ennio

(57) **Abstract**

A lead-frame (400) for electronic devices (500) is proposed; the lead-frame is produced from a metal plate and includes a bearing structure (105) arranged in a first plane, and for each electronic device a support element (420) spaced apart from the first plane having a first surface (512) facing the bearing structure for mounting at least one chip (205) and an opposed second surface (515) for being exposed from the electronic device, the second surface being arranged in a second plane, and a plurality of interconnection elements (115) connecting the support element to the bearing structure. For each electronic device the lead-frame further includes an intermediate area (425) between the support element and the interconnection elements, the intermediate area being arranged in a third plane between the first and the second planes.

## Description

The present invention relates to a lead-frame for electronic devices.

An electronic device generally includes a circuit that is integrated on a chip of semiconductor material. The chip requires for its utilization to be housed in a package. The package consists of an insulating body, which protects the chip and a die pad onto which the chip is mounted; multiple leads projecting from the insulating body are used to connect the chip to external circuits. For this purpose, the electronic device is typically mounted onto a Printed Circuit Board, or shortly PCB.

In packages for power applications, the die pad has a surface that is exposed with respect to the insulating body (exposed-pad packages). The die pad then acts as a heat dissipator, which is soldered in contact with the PCB.

Those electronic devices are fabricated from a lead-frame, which is typically produced by a dieing of a thin metal plate. The lead-frame consists of a bearing structure, from which the leads project; a plurality of die pads are connected to the bearing structure by means of interconnection bars (that support the die pads during the fabrication process of the electronic devices).

In order to obtain exposed-pad packages it is necessary to press the die pads, so that they are spaced apart from the bearing structure and the leads (in jargon, this operation is called downsetting). During the downsetting operation the ending portions of the interconnection bars connected to the die pads inevitably bend, thereby adversely affecting the planarity of the surface in contact with the PCB. A non-flat surface of the die pad can impair the connection with the PCB; this is detrimental to the robustness and the heat removal capability of the electronic device. Furthermore, the bent ending portions of the interconnection bars can cause flashes during a molding process for producing the insulating bodies.

Additionally, it has to be observed that the thickness of the die pad must be maintained relatively high. Indeed, a too thin die pad impairs the adhesion of the insulating body to the lateral facets of the die pad (being the area of the lateral facets proportional to their thickness); this implies a reduced robustness of the electronic device.

It is an object of the present invention to overcome the above-mentioned drawbacks. In order to achieve this object, a lead-frame for electronic devices as set out in the first claim is proposed.

Briefly, an aspect of the present invention provides a lead-frame for electronic devices being produced from a metal plate, the lead-frame including a bearing structure arranged in a first plane, and for each electronic device a support element spaced apart from the first plane having a first surface facing the bearing structure for mounting at least one chip and an opposed second surface for being exposed from the electronic device, the second surface being arranged in a second plane, and a plurality of interconnection elements connecting the support element to the bearing structure, wherein for each electronic device the lead-frame further includes an intermediate area between the support element and the interconnection elements, the intermediate area being arranged in a third plane between the first and the second planes.

Moreover, the present invention provides an electronic device fabricated from that lead-frame. Corresponding methods of producing a lead-frame and of fabricating an electronic device from that lead-frame are also encompassed.

Further features and the advantages of the solution according to the present invention will be made clear by the following description of a preferred embodiment thereof, given purely by way of a non-restrictive indication, with reference to the attached figures, in which:
Fig.1 shows partial top and elevation views of a conventional lead-frame;
Fig.2 schematically shows a cross sectional side view of an electronic device fabricated from the lead-frame of Fig.1;
Fig.3 is a 3D representation of a die pad of the electronic device illustrated in Fig.2;
Fig.4 shows partial top and elevation views of a lead-frame according to an embodiment of the present invention;
Fig.5 schematically shows a cross sectional side view of an electronic device fabricated from the lead-frame of Fig.4; and
Fig.6 is a 3D representation of the die pad of the electronic device illustrated in Fig.5.

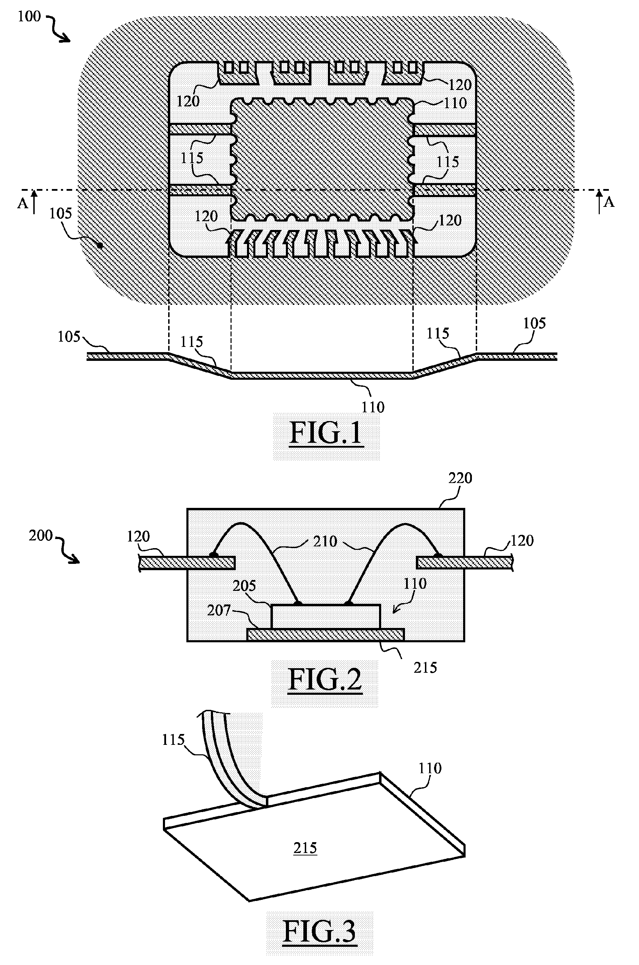

With reference particularly to Fig.1, partial top and elevation views of a conventional lead-frame 100 are illustrated. The lead-frame 100 is produced from a thin conductive plate (for example, a metal plate, such as a plate of copper) .

The lead-frame 100 includes a bearing structure 105. A plurality of die pads 110 (only one shown in the drawing) are formed in the metal plate. Each die pad 110, having roughly a rectangular shape, is intended to hold an electronic circuit (integrated on a chip of semiconductor material) on its upper surface.

A plurality of interconnection bars 115 connects the die pad 110 to the bearing structure 105. For example, two interconnection bars 115 extend from each shorter side of the die pad 110 to a facing portion of the bearing structure 105.

The lead-frame 100 further includes a plurality of leads 120 for each die pad 110. Particularly, two sets of leads 120 project from respective portions of the bearing structure 105 facing the longer sides of the die pad 110.

The die pads 110 are spaced apart from the bearing structure 105 (and, consequently, from the leads 120). Typically, a distance D between a plane of the bearing structure 105 and a plane of the die pad 110 (called downsetting depth) is of about 1-2 mm.

The lead-frame 100 is produced by dieing the metal plate (so as to define the die pads 110, the bearing structure 105, the interconnection bars 115 and the leads 120). The lead-frame 100 is then subjected to a downsetting operation, wherein all the die pads 110 are pressed by means of a corresponding die.

Referring to Fig.2, a cross sectional side view of an electronic device 200 fabricated from the lead-frame of Fig.1 is schematically shown.

The electronic device 200 includes a chip 205, which is mounted onto the upper surface 207 of the die pad 110 (facing the leads 120) by means of a binding material (such as an adhesive compound). Tiny metal wires 210 (typically, made of copper or gold) electrically connect the die pad 110 to a proximal end of the corresponding leads 120.

The chip 205 and the wires 210 are protected by an insulating body 220 (made of a plastic material, such as a resin). The insulating body 220 also embeds (in addition to the chip 205 and the wires 210) an internal portion of the leads 120 (whereto the wires 210 are connected) and a portion of the interconnection bars (not visible in the drawing) extending from the die pad 110. Conversely, an active portion of the leads 120 and a portion of the interconnection bars extending from the bearing structure of the lead-frame are maintained outside the insulating body 220.

The downsetting of the die pad 110 allows achieving a better looping of the wires 210. Furthermore, a deep downsetting of the die pad 110 allows maintaining its lower surface 215 (opposite the upper surface 207 onto which the chip 205 is mounted) exposed from the insulating body 220.

During a fabrication process, one chip 205 is mounted onto each die pad 110 of the lead-frame; the chip 205 is then connected to the corresponding leads 120 through the wires 210. Each structure so obtained is embedded into the insulating body 220 by means of a molding process. The electronic devices 200 are then separated from the bearing structure of the lead-frame by cutting the portions of the interconnection bars projecting from the insulating body 220 and the ending portions of the leads 120 (connected to the bearing structure) .

Typically, the electronic device 200 is mounted onto a PCB, which consists of an insulating substrate on which conductive strips are patterned. For this purpose, the exposed surface 215 of the die pad 110 is soldered onto the PCB. The leads 120 of the electronic device 200 are then mechanically and electrically connected to the desired conductive strips of the PCB. The die pad 110 in contact with the PCB increases the heat dissipation during the operation of the electronic device 200; additionally, the die pad 110 can be connected to ground, thus reducing loop inductance for high-frequency applications.

Fig.3 is a 3D representation of the die pad 110 of the electronic device of Fig.2; for the sake of simplicity, only one of the interconnection bars 115 projecting from the die pad 110 is illustrated.

As can be seen, an ending portion of the interconnection bar 115 connected to the die pad 110 bents because of the stress undergone during the downsetting operation. As a consequence, the bent ending portion of the interconnection bar 115 is exposed from the insulating body of the electronic device (together with the lower surface 215 of the die pad 110); as a consequence, the planarity of the exposed surface 215 of the die pad 110 is impaired. Moreover, this can cause flashes during the molding process for producing the insulating body.

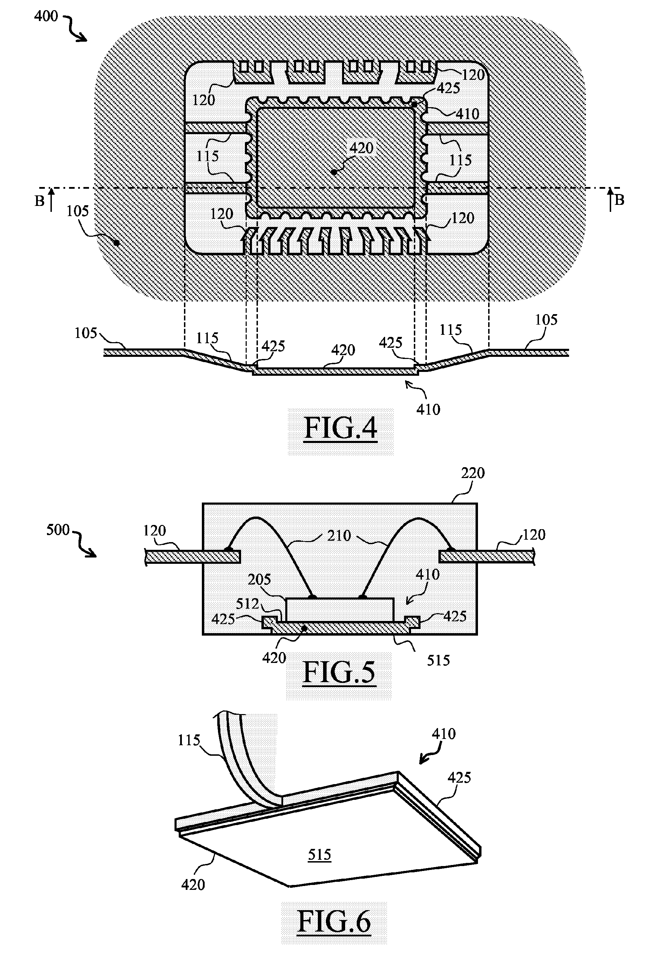

Considering now Fig.4, partial top and elevation views of a lead-frame 400 according to a preferred embodiment of the present invention are shown (the elements corresponding to those depicted in Fig.1 are denoted with the same references and their explanation is omitted for the sake of simplicity).

The lead-frame 400 is similar to the one of Fig.1 and includes a plurality of die pads 410 (corresponding to the die pad 110 of Fig.1); however, the lead-frame 400 differs in that each die pad 410 has a biplanar geometry. Particularly, an internal rectangular portion 420 of the die pad 410 is lowered with respect to an external portion 425. The internal portion 420 defines a support area that is used to mount the chip, while the external portion 425 defines a boundary frame that is interposed between the support area 420 and the interconnection bars 115. The boundary frame 425 is very narrow; for example, in a die pad 410 of 6.8x4.5 mm, the width of the boundary frame 425 is of the order of hundreds of micrometers (such as 400-600 µm).

In this way, the bearing structure 105, the boundary frame 425 and the support area 420 are arranged in three distinct planes (parallel to one another); particularly, the plane of the boundary frame 425 is arranged between the plane of the bearing structure 105 and the plane of the support area 420 (*i.e*., the plane of its exposed surface).

The distance between the plane of the boundary frame 425 and the plane of the support area 420 is in the range from 40% to 60% of a thickness of the lead-frame 400; preferably, this distance is in the range from 45% to 55%, and more preferably is about 50%, of the thickness of the lead-frame 400. Typically, the thickness of the lead-frame 400 is of a few hundreds of micrometers, such as 200 µm, and the distance between the plane of the boundary frame 425 and the plane of the support area 420 is, for example, about 100-150 µm.

For producing the lead-frame 400, firstly, the dieing process is performed on the metal plate thus obtaining the die pads 410, the bearing structure 105, the interconnection bars 115 and the leads 120. The die pads 410 are then extruded (for example, by a die) for defining the respective support areas 420 and boundary frames 425. By executing then the downsetting operation on all the die pads 410, the plane of their boundary frames 425 is moved at an intermediate position between the respective support areas 420 and the bearing structure 105.

Alternatively, the lead-frame is made of a different metal (or of another conductive material), the die pads have different shapes, or another number of interconnection bars are provided. Furthermore, the interconnection bars and the leads can be arranged elsewhere, or a different downsetting depth can be used. However, the concepts of the present invention are also applicable when the die pads, their boundary frames and their support areas have different sizes. Moreover, the lead-frame can be produced in an alternative manner and, particularly, the steps required for producing the lead-frame can be carried out in a different order.

Referring to Fig.5, a cross sectional side view of an electronic device 500 fabricated from the lead-frame of Fig.4 is schematically shown.

In this case, the chip 205 is mounted onto the upper surface 512 of the support area 420 of the die pad 410, while its lower surface 515 is maintained exposed from the insulating body 220. Conversely, the boundary frame 425 of the die pad 410 is completely embedded in the insulating body 220.

Therefore, the adhesion of the plastic material of the insulating body 220 to the lateral facets of the die pad 410 is improved. In fact, the area of the lateral facets of the die pad 410 is increased with respect to the area of the lateral facets of a conventional die pad having the same thickness. Moreover, the boundary frame 425 improves the gripping of the insulating body 220.

Additionally, it should be observed that the boundary frame 425 forms a raised step with respect to the support area 420, so that the die pad 410 is substantially tray-shaped. Such a structure allows containing any excess of the binding material that is used for mounting the chip 205 onto the die pad 410 (avoiding its spilling outside the die pad 410).

Alternatively, the insulating body and/or the wires are made of different materials; moreover, two or more chips (even of the opto-electronic type) can be mounted onto the die pad. In any case, the use of the electronic device in different applications is not excluded (even if the electronic device is not soldered onto any PCB).

Fig.6 is a 3D representation of the die pad 110 of the electronic device of Fig.4 (with only one of the interconnection bars 115).

As can be seen, the bent portions of the interconnection bars 115 (connected to the boundary frame 425 of the die pad 410) are located in an intermediate position between the bearing structure of the lead-frame and the exposed surface 515.

As a consequence, also the bent portions of the interconnection bars 115 are completely embedded in the insulating body (together with the boundary frame 425); in this way, the planarity of the surface of the die pad 410 in contact with the PCB is not impaired.

More generally, an aspect of the present invention proposes a lead-frame for electronic devices, which is produced from a metal plate. The lead-frame includes a bearing structure arranged in a first plane. For each electronic device a support element spaced apart from the first plane is provided. The support element has a first surface facing the bearing structure (for mounting one or more chips) and an opposed second surface (for being exposed from the electronic device); the second surface is arranged in a second plane. A plurality of interconnection elements connects the support element to the bearing structure. For each electronic device, the lead-frame further includes an intermediate area between the support element and the interconnection elements; the intermediate area is arranged in a third plane between the first and the second planes.

The proposed lead-frame allows producing electronic devices with an improved planarity of the surface of the support element that is exposed from the electronic device. As a consequence, the whole area of the exposed surface of the electronic device can be exploited, for example, for the soldering onto a PCB; this provides an increased robustness and a more effective heat removal capability.

In addition, the devised structure ensures an improved adhesion of the insulating body of the electronic device to the support element (with respect to a conventional lead-frame having a support element of the same thickness). As a consequence, the thickness of the proposed lead-frame can be reduced (for the same robustness) .

The preferred embodiment of the invention described above offers further advantages.

Particularly, the planes of the bearing structure, of the external portion of the die pad and of its support portion are substantially parallel.

This structure exploits the solution of the invention at its best.

Preferably, the interconnection bars are connected to an external portion of the die pad (with its internal portion that defines the support element).

In this way, the desired results can be easily obtained by a very simple process.

As a further enhancement, the external portion of the die pad is a boundary frame.

This configuration further improves the robustness of the electronic device; additionally, it avoids the spilling of any excess of the binding material outside the die pad.

A suggested choice for implementing the lead-frame is to maintain the distance between the boundary frame and the exposed surface of the support area in the range from 40% to 60% of the thickness of the die pad.

Preferably, that distance is substantially equal to 50% of the thickness of the die pad.

The proposed values are a good compromise between the opposed requirements of high performance and simplicity.

Advantageously, the lead-frame of the invention is produced extruding the die pads so as to define the corresponding boundary frames.

The proposed technique requires minor changes to the standard process that are already in use.

However, the lead-frame according to the present invention is also suitable to be implemented with a different arrangement of its elements. For example, the provision of the boundary frame in a plane slightly sloped (with respect to the die pad) is not excluded. Moreover, the intermediate area can have a different shape; for example, in different embodiments of the invention the intermediate area consists of two strips (at the borders of the die pad from which the interconnection bars project), or the intermediate area is formed by the ending portions of the interconnection bars (close to the die pad). Alternatively, a different distance between the boundary frame and the support area can be chosen (either lower than 40% or higher than 60% of the thickness of the die pad). In any case, the use of another process for producing the lead-frame is not excluded; for example, the steps of extruding and pressing can be inverted, or the boundary frames can be extruded with an equivalent technique.

Naturally, in order to satisfy local and specific requirements, a person skilled in the art may apply to the solution described above many modifications and alterations all of which, however, are included within the scope of protection of the invention as defined by the following claims.

## Claims

1. A lead-frame (400) for electronic devices (500) being produced from a metal plate, the lead-frame including a bearing structure (105) arranged in a first plane, and for each electronic device
a support element (420) spaced apart from the first plane having a first surface (512) facing the bearing structure for mounting at least one chip (205) and an opposed second surface (515) for being exposed from the electronic device, the second surface being arranged in a second plane, and
a plurality of interconnection elements (115) connecting the support element to the bearing structure,
**characterized in that**
for each electronic device the lead-frame further includes an intermediate area (425) between the support element and the interconnection elements, the intermediate area being arranged in a third plane between the first and the second planes.

2. The lead-frame (400) according to claim 1, wherein the first, the second and the third planes are substantially parallel.

3. The lead-frame (400) according to claim 1 or 2, further including for each electronic device (500) a pad (410), the pad having an internal portion (420) defining the support element and an external portion (425) defining the intermediate area.

4. The lead-frame (400) according to claim 3, wherein the external portion (425) consists of a boundary frame.

5. The lead-frame (400) according to any claim from 1 to 4, wherein a distance between the second plane and the third plane ranges from 40% to 60% of a thickness of the support element (420).

6. The lead-frame (400) according to claim 5, wherein the distance between the second plane and the third plane is substantially equal to 50% of the thickness of the support element (420).

7. An electronic device (500) fabricated using the lead-frame (400) according to any claim from 1 to 6, the electronic device including
the support element (420),
at least one chip (205) mounted onto the first surface (512) of the support element,
the intermediate area (425),
a portion of the interconnection elements (115) extending from the intermediate area, and
an insulating body (220) embedding the support element except the second surface (515) thereof, the at least one chip, the intermediate area, and the portion of the interconnection elements.

8. A method of producing a lead-frame (400) for electronic devices (500) from a metal plate, the method including the steps of:
forming a bearing structure (105) arranged in a first plane;
for each electronic device forming a support element (420) spaced apart from the first plane having a first surface (512) for mounting at least one chip (205) and an opposed second surface (515) for being exposed from the electronic device, the second surface being arranged in a second plane; and
forming a plurality of interconnection elements (115) connecting the support element to the bearing structure,
**characterized in that**
the method further includes the step of forming an intermediate area (425) between the support element and the interconnection elements, the intermediate area being arranged in a third plane between the first and the second planes.

9. The method according to claim 8, further including for each electronic device (500) the steps of:
forming a pad (410);
extruding the pad for defining the support element (420) in an internal portion and the intermediate area (425) in an external portion thereof; and
pressing the pad to move the second surface (515) to the second plane.

10. A method of fabricating electronic devices (500) including the steps of:
producing a lead-frame (400) according to the method of claim 8 or 9;
for each electronic device (500) mounting at least one chip (205) onto the first surface (512) of the support element (420);
forming an insulating body (220) embedding the support element except the second surface (515) thereof, the at least one chip, the intermediate area (425) and a portion of the interconnection elements (115) extending from the intermediate area; and
cutting the interconnection elements projecting from the insulating body for separating the electronic device from the bearing structure (105).
